# EUROPEAN PATENT APPLICATION

(11) **EP 2 837 941 A1**
(43) Date of publication of application: **18.02.2015**
(21) Application number: 13775193.9
(22) Date of filing: 28.02.2013
(51) Int. Cl.: G01R 15/14

(54) **SHUNT RESISTANCE TYPE CURRENT SENSOR**

(30) Priority: 13.04.2012 JP 2012092134
(71) Applicant: Yazaki Corporation, Minato-ku Tokyo 108-8333 (JP)
(72) Inventor: KOMAI, Katsuya, Susono-shi, Shizuoka 410-1194 (JP); SATO, Takashi, Susono-shi, Shizuoka 410-1194 (JP)
(74) Representative: Grünecker, Kinkeldey, Stockmair & Schwanhäusser
(86) International application number: PCT/JP2013/055483
(87) International publication number: WO 2013/153874

(57) **Abstract**

A shunt type current sensor (1) using an infrared ray temperature detection unit as a temperature sensor (60) can detect the temperature of a shunt resistance portion (SR) directly through the detection of infrared rays radiated from the shunt resistance portion (SR). Such a detection method is not so much affected by thermal loss, as compared with a method for detecting a temperature in a course of sequential heat conduction via a bus bar (10) and a circuit board (20). It is therefore possible to suppress a gap between the temperature of the shunt resistance portion (SR) and the detected temperature.

## Description

### Technical Field

The present invention relates to a shunt resistance type current sensor.

### Background Art

In the background art, a shunt resistance type current sensor, in which a current to be measured is applied to a shunt resistance portion having a known resistance value and a voltage drop appearing in the shunt resistance portion is detected so that the magnitude of the current to be measured can be detected, has been proposed in order to detect a pulse current, an AC large current, etc. In such a shunt resistance type current sensor, the resistance value of the shunt resistance portion may change depending on temperature. Therefore, the temperature of the shunt resistance portion is detected, and the resistance value is corrected in accordance with the detected temperature. Particularly when a temperature dependency coefficient relating to the shunt resistance portion is large, it is necessary to accurately detect the temperature of the shunt resistance portion. To this end, a temperature sensor is also mounted on a circuit board which is mounted with a voltage detection IC etc. for detecting the voltage drop.

In Patent Literature 1, a bus bar connected to a negative pole terminal of a battery also serves as a shunt resistance portion to be used for detecting a current of the battery. Two poles for detecting a potential difference in the bus bar are connected to the circuit board, and a temperature detecting element is mounted on the circuit board. In this case, the temperature detecting element is disposed near one of the poles so as to enhance the connectivity to the temperature of the bus bar.

### Prior Technical Document

### Patent Document

Patent Document 1: JP-A-2009-40314

### Summary of the Invention

### Problem that the Invention is to Solve

However, in the method disclosed in Patent Literature 1, heat is conducted in turns from the bus bar to the temperature detecting element through the poles and the circuit board. Therefore, there arises a trouble that a gap may be generated between the temperature of the bus bar and the temperature (detected temperature) detected by the temperature detecting element, or a delay may be generated until the heat is conducted from the bus bar to the temperature detecting element. Thus, there is a problem that the accuracy in calculating the current is lowered due to an error included in the calculated resistance value or deterioration in responsiveness to a temperature change of the bus bar.

The present invention has been developed in consideration of the problem. An object of the invention is to accurately detect the temperature of a bus bar as a base of a resistance value, so that the accuracy in detecting a current can be improved.

### Means for Solving the Problem

In order to solve the problem, the present invention provides a shunt resistance type current sensor including: a bus bar which has a substantially plate-like shape; a circuit board which is mounted on the bus bar; a pair of connection terminal portions which electrically connect the circuit board and the bus bar to each other; a voltage detection unit which is mounted on the circuit board and which detects a value of a voltage applied to the circuit board through the pair of connection terminal portions to detect magnitude of a current to be measured flowing in the bus bar; and a temperature detection unit which is provided in the circuit board and which detects a temperature for correction performed by the voltage detection unit. In this case, the temperature detection unit is an infrared temperature detection unit which detects infrared rays radiated from the bus bar to detect the temperature.

Here, in the invention, it is preferable that the temperature detection unit is provided on a surface of the circuit board which faces the bus bar.

In addition, in the invention, the shunt resistance type current sensor may further include an infrared ray high radiation portion which is formed in a region in the bus bar which faces the temperature detection unit. In this case, it is preferable that the infrared ray high radiation portion has a high infrared ray radiation rate, in comparison with a region in the bus bar where the infrared ray high radiation portion is not formed, when heat is applied under the same thermal conditions.

### Advantage of the INVENTION

According to the invention, temperature detection is hardly affected by thermal loss in comparison with a method for detecting a temperature in a course of heat conduction via a bus bar and a circuit board. It is therefore possible to suppress a gap between the temperature of the bus bar and the detected temperature. In addition, the temperature of the bus bar can be detected directly avoiding the heat conduction path such as the circuit board where loss may be generated easily. It is therefore possible to acquire a temperature change in the bus bar promptly. Thus, it is possible to accurately detect the temperature of the bus bar as a base of a resistance value, so that it is possible to suppress such a trouble that the calculated resistance value may include an error or the responsiveness to the temperature change of the bus bar may deteriorate. As a result, it is possible to improve the accuracy in calculating a current.

### Brief Description of the Drawings

[Fig. 1] Fig. 1 is a top view schematically showing a shunt resistance type current sensor according to an embodiment of the invention.
[Fig. 2] Fig. 2 is a side view schematically showing the shunt resistance type current sensor shown in Fig. 1.
[Fig. 3] Fig. 3 is a top view schematically showing a bus bar of the shunt resistance type current sensor.
[Fig. 4] Fig. 4 is a sectional view showing the bus bar shown in Fig. 3 and taken along line IV-IV.
[Fig. 5] Fig. 5 is an explanatory view schematically showing a use state of the shunt resistance type current sensor.

### Mode for Carrying Out the Invention

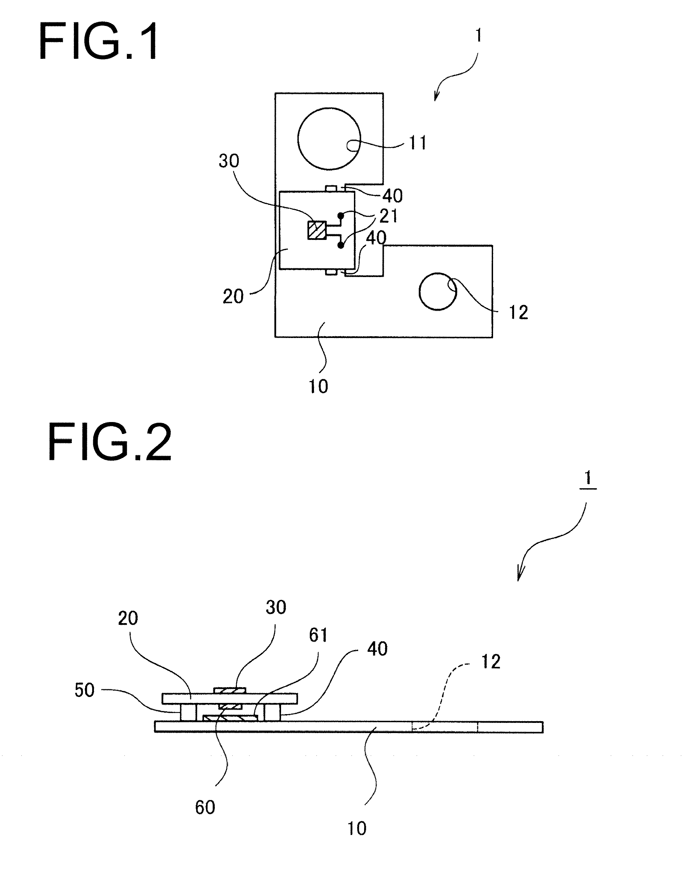

Fig. 1 is a top view schematically showing a shunt resistance type current sensor 1 according to an embodiment of the invention. Fig. 2 is a side view schematically showing the shunt resistance type current sensor 1 shown in Fig. 1. The shunt resistance type current sensor 1 according to the embodiment is used as a battery terminal and includes a bus bar 10, a circuit board 20 and a voltage detection IC 30.

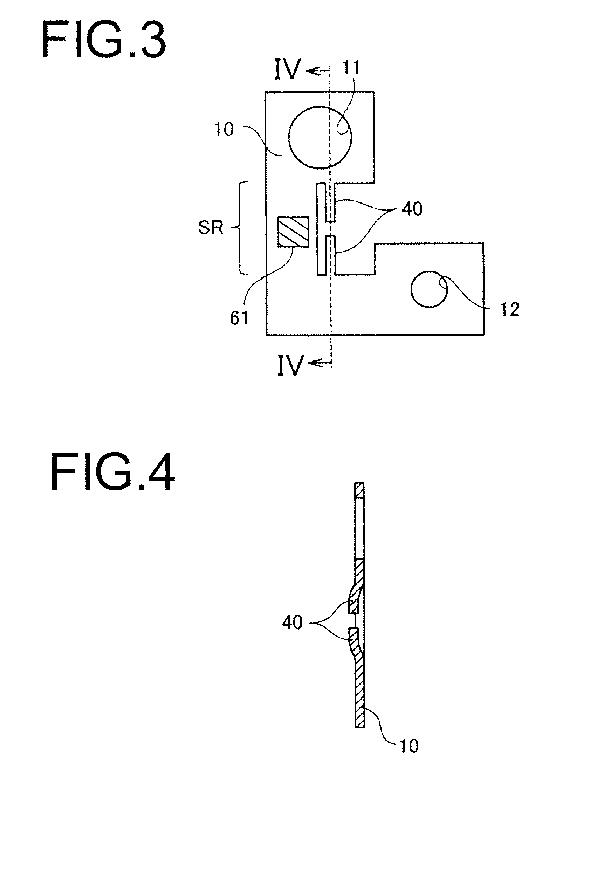

Fig. 3 is a top view schematically showing the bus bar 10 of the shunt resistance type current sensor 1. The bus bar 10 is a substantially plate-like conductive member, which is, for example, made of a copper-manganese alloy, a copper-nickel alloy, or the like. The bus bar 10 has a configuration in which a shunt resistance portion SR is included in a part of the bus bar 10 so that a current to be measured can flow therein.

The bus bar 10 is formed into a desired shape by press-forming out of a plate-like steel material. The bus bar 10 is, for example, formed into a substantially L-shape, and through holes 11 and 12 are formed in the end portions of the L-shape respectively. One through hole 11 serves as a hole for a battery post, and the other through hole 12 serves as a hole for a wire harness fixing screw.

Fig. 4 is a sectional view showing the bus bar 10 shown in Fig. 3 and taken along line IV-IV. The shunt resistance type current sensor 1 has a pair of connection terminal portions 40. The connection terminal portions 40 are provided correspondingly to the opposite end portions of the shunt resistance portion SR respectively, so as to electrically connect the circuit board 20 and the bus bar 10 with each other. Each of the connection terminal portions 40 is, for example, formed out of the same material as the bus bar 10 so as to extend from the bus bar 10. The bus bar 10 and the connection terminal portions 40 are formed concurrently by press-forming out of a plate-like steel material.

Each connection terminal portion 40 is formed to extend toward the inside of a part of the bus bar 10 where the circuit board 20 is mounted, so as to face the other connection terminal portion 40. In addition, each connection terminal portion 40 has a cantilever-like shape raised in comparison with the flat plate portion of the bus bar 10. The free end side of each connection terminal portion 40 is electrically connected to the circuit board 20 by soldering. In addition, each connection terminal portion 40 is made larger in widthwise size than in lengthwise size.

Refer to Figs. 1 and 2 again. The circuit board 20 is mounted on the bus bar 10. A circuit pattern 21 is formed in the circuit board 20. End portions of the circuit pattern 21 are connected to the free end terminal sides of the aforementioned connection terminal portions 40, and electrically connected to the bus bar 10.

Spacers 50 are members which are put between the bus bar 10 and the circuit board 20. Since the connection terminal portions 40 formed like cantilevers are located in positions higher than the flat plate portion of the bus bar 10, the circuit board 20 is also disposed in a position higher than the flat plate portion of the bus bar 10. Therefore, the spacers 50 are put in, of the portion where the circuit board 20 is mounted, a region on the opposite side to the connection terminal portions 40, so that the circuit board 20 can be supported.

The voltage detection IC 30 is mounted on the circuit pattern 21 formed in the circuit board 20. The voltage detection IC 30 detects a voltage value applied to the circuit board 20 (the voltage detection IC 30 corresponds to a voltage detection unit) in order to detect the magnitude of the current to be measured flowing in the bus bar 10). That is, the voltage detection IC 30 detects a voltage drop occurring in the shunt resistance portion SR of the bus bar 10, and then detects the magnitude of the current to be measured flowing in the bus bar 10 based on the voltage drop.

In addition, the voltage detection IC 30 makes correction of the resistance value in accordance with a detection result obtained by a temperature sensor 60 which will be described later. That is, the voltage detection IC 30 corrects the resistance value in the shunt resistance portion SR in accordance with a temperature result so as not to detect a wrong current value due to influence of a resistance change caused by a change in temperature.

In addition, the shunt resistance type current sensor 1 further includes the temperature sensor 60. The temperature sensor 60 is provided on a surface of the circuit board 20 which faces the shunt resistance portion SR of the bus bar 10. In the embodiment, the temperature sensor 60 is provided on a surface of the circuit board 20 on the opposite side to the surface of the circuit board 20 where the voltage detection IC 30 is mounted. Therefore, the temperature sensor 60 can detect the temperature of the shunt resistance portion SR located in a position facing the temperature sensor 60. In addition, for example, the temperature sensor 60 is disposed in a position corresponding to a central portion of the shunt resistance portion SR in the bus bar 10 or specifically in a central portion of the shunt resistance portion SR based on the flowing direction of the current.

One of the characteristics of the embodiment is that the temperature sensor 60 corresponds to an infrared temperature detection unit which receives infrared rays radiated from an object to be measured, and detects a temperature thereof. The temperature sensor 60 is disposed in a manner to allow its infrared detection surface to face the shunt resistance portion SR, so that the temperature sensor 60 can detect infrared rays radiated from the bus bar 10 or particularly the shunt resistance portion SR. Thus, the temperature sensor 60 can detect the temperature of the shunt resistance portion SR. A device using a thermopile, a device using a pyroelectric element, etc. may be applied to the infrared temperature detection unit.

On the other hand, an infrared ray high radiation portion 61 is formed in a region in the bus bar 10 which faces the temperature sensor 60. The infrared ray high radiation portion 61 has such a function that the radiation rate of infrared rays in the infrared ray high radiation portion 61 is made higher than that in the region where the infrared ray high radiation portion 61 is not formed when heat is applied under the same thermal conditions. The infrared ray high radiation portion 61 may be formed, for example, by coating with black body paint or pasting of black body tape. Incidentally, as long as the aforementioned function can be obtained, various forms having a function of enhancing the radiation rate, such as black paint or tape, may be applied to the infrared ray high radiation portion 61.

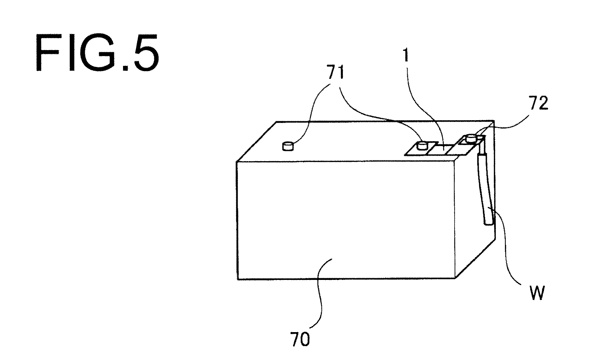

Fig. 5 is an explanatory view schematically showing a use state of the shunt resistance type current sensor 1 according to the embodiment. The bus bar 10 of the shunt resistance type current sensor 1 according to the embodiment is used as a battery terminal. For example, the through hole 11 of the bus bar 10 is connected to a negative-side battery post 71 of a battery 70, and the other through hole 12 is connected to a wire harness W through a wire harness fixing screw 71.

Next, the operation of the shunt resistance type current sensor 1 according to the embodiment will be described. As shown in the use state of the shunt resistance type current sensor 1, the bus bar 10 of the shunt resistance type current sensor 1 is connected to the battery post 71 and the wire harness W. In this case, charging/discharging of the battery 70 changes in accordance with the traveling condition of a vehicle. Therefore, the bus bar 10 or more specifically the shunt resistance portion SR changes in temperature due to Joule heat generation at any time.

Here, according to the embodiment, in spite of the situation in which such a temperature change may occur, the temperature sensor 60 can detect the temperature of the shunt resistance portion SR directly through the detection of infrared rays radiated from the shunt resistance portion SR because the infrared temperature detection unit is used as the temperature sensor 60. Such a detection method is not so much affected by thermal loss, as compared with a method for detecting a temperature in a course of sequential heat conduction via the bus bar 10 and the circuit board 20. It is therefore possible to suppress a gap between the temperature of the shunt resistance portion SR and the detected temperature. In addition, when the temperature of the shunt resistance portion SR is detected directly avoiding the conduction path such as the circuit board 20 in which loss may be generated easily, the temperature change can be acquired promptly. Thus, the temperature of the bus bar as a base of the resistance value can be detected accurately. It is therefore possible to suppress such a problem that the calculated resistance value may include an error or the responsiveness to the temperature change of the bus bar may deteriorate. As a result, it is possible to improve the accuracy in calculating the current.

In addition, in the embodiment, the temperature sensor 60 is provided in the surface which faces the bus bar 10 (more specifically the shunt resistance portion SR) in the circuit board 20. Accordingly, infrared rays radiated from the shunt resistance portion SR can be detected efficiently in the temperature sensor 60. Thus, it is possible to improve the accuracy in detecting the temperature. It is therefore possible to improve the accuracy in calculating the current.

In addition, in the embodiment, the infrared ray high radiation portion 61 is formed in the region which faces the temperature sensor 60 in the bus bar 10, and the infrared ray high radiation portion 61 has a higher infrared ray radiation rate than the region where the infrared ray high radiation portion 61 is not formed when heat is applied under the same thermal conditions. Due to the configuration made thus, it is possible to improve the efficiency in detecting the infrared rays radiated from the shunt resistance portion SR in the temperature sensor 60. Thus, it is possible to improve the accuracy in detecting the temperature. It is therefore possible to improve the accuracy in calculating the current.

In addition, as shown in the embodiment, the temperature sensor 60 is disposed in a position corresponding to the central portion of the shunt resistance portion SR so that the temperature of the central portion of the shunt resistance portion SR can be detected by the temperature sensor 60. Accordingly, the approximately average temperature of the shunt resistance portion SR can be detected, for example, in spite of a situation in which a temperature difference may occur between the battery post 71 side and the wire harness W side in the bus bar 10 due to some traveling condition of the vehicle. Thus, the temperature of the shunt resistance portion SR as a base of the resistance value can be detected accurately. It is therefore possible to improve the accuracy in detecting the current.

Incidentally, when the temperature sensor 60 is disposed in a position corresponding to the central portion of the shunt resistance portion SR, strict correspondence is not required, but it is sufficient that the temperature sensor 60 is disposed in a position substantially corresponding to the central portion as long as the approximately average temperature of the shunt resistance portion SR can be detected.

The shunt resistance type current sensor according to the embodiment has been described above. However, the present invention is not limited to the embodiment, but various changes may be made within the scope of the invention. For example, although the embodiment has a form in which a part of the bus bar is included as the shunt resistance portion, the invention is not limited thereto but may have a form in which the whole of the bus bar is included as the shunt resistance portion.

Here, the characteristics of the aforementioned embodiment of the shunt resistance type current sensor according to the invention can be briefly summed up and listed in the following paragraphs [1] to [3].
[1] A shunt resistance type current sensor (1) including:
   a bus bar (10) which has a substantially plate-like shape;
   a circuit board (20) which is mounted on the bus bar (10);
   a pair of connection terminal portions (40) which electrically connect the circuit board (20) and the bus bar (10) to each other;
   a voltage detection IC (30) which is mounted on the circuit board (20) and which detects a value of a voltage applied to the circuit board (20) through the pair of connection terminal portions (40) to detect magnitude of a current to be measured flowing in the bus bar (10); and
   a temperature sensor (60) which is provided in the circuit board (20) and which detects a temperature for correction performed by the voltage detection IC (30),
   wherein the temperature sensor (60) is an infrared temperature detection unit which detects infrared rays radiated from the bus bar (10) to detect the temperature.
[2] The shunt resistance type current sensor (1) according to the paragraph [1], wherein the temperature sensor (60) is provided on a surface of the circuit board (20) which faces the bus bar (10).
[3] The shunt resistance type current sensor (1) according to the paragraph [2], further including:
   an infrared ray high radiation portion (61) which is formed in a region in the bus bar (10) which faces the temperature sensor (60),
   wherein the infrared ray high radiation portion (61) has a high infrared ray radiation rate, in comparison with a region in the bus bar (10) where the infrared ray high radiation portion (61) is not formed, when heat is applied under the same thermal conditions.

Although the prevent invention has been described in detail or with reference to its specific embodiment, it is obvious for those skilled in the art that various changes or modifications may be made on the invention without departing from the spirit and scope of the invention.

The present application is based on a Japanese patent application (Patent Application No. 2012-92134) filed on April 13, 2012, the contents of which will be incorporated herein.

### Industrial Applicability

According to the present invention, the temperature of a bus bar as a base of a resistance value can be detected accurately. It is therefore possible to suppress such a problem that a calculated resistance value may include an error or responsiveness to a temperature change of the bus bar may deteriorate. The invention obtaining such an effect is useful in the field of shunt resistance type current sensors.

### Description of Reference Numerals and Signs

- 1: shunt resistance type current sensor
- 10: bus bar
- 11: through hole
- 12: through hole
- 20: circuit board
- 21: circuit pattern
- 30: voltage detection IC
- 40: connection terminal portion
- 50: spacer
- 60: temperature sensor
- 61: infrared ray high radiation portion
- 70: battery
- 71: battery post
- 72: fixing screw
- SR: shunt resistance portion
- W: wire harness

## Claims

1. A shunt resistance type current sensor, comprising:
a bus bar which has a substantially plate-like shape;
a circuit board which is mounted on the bus bar;
a pair of connection terminal portions which electrically connect the circuit board and the bus bar to each other;
a voltage detection unit which is mounted on the circuit board and which detects a value of a voltage applied to the circuit board through the pair of connection terminal portions to detect magnitude of a current to be measured flowing in the bus bar; and
a temperature detection unit which is provided in the circuit board and which detects a temperature for correction performed by the voltage detection unit,
wherein the temperature detection unit is an infrared temperature detection unit which detects infrared rays radiated from the bus bar to detect the temperature.

2. The shunt resistance type current sensor according to claim 1, wherein the temperature detection unit is provided on a surface of the circuit board which faces the bus bar.

3. The shunt resistance type current sensor according to claim 2, further comprising:
an infrared ray high radiation portion which is formed in a region in the bus bar which faces the temperature detection unit,
wherein the infrared ray high radiation portion has a high infrared ray radiation rate, in comparison with a region in the bus bar where the infrared ray high radiation portion is not formed, when heat is applied under the same thermal conditions.
